(19) Europäisches Patentamt
European Patent Office
Office européen des brevets

(11) **EP 0 862 813 B1**

(12) **FASCICULE DE BREVET EUROPEEN**

(45) Date de publication et mention
de la délivrance du brevet:
**24.11.1999 Bulletin 1999/47**

(21) Numéro de dépôt: 96937377.8

(22) Date de dépôt: 31.10.1996

(51) Int Cl.⁶: **H03H 9/145**

(86) Numéro de dépôt international:
**PCT/FR96/01717**

(87) Numéro de publication internationale:
**WO 97/17756 (15.05.1997 Gazette 1997/21)**

(54) **TRANSDUCTEUR A ONDES ACOUSTIQUES DE SURFACE ATTAQUE EN DIFFERENTIEL**

DIFFERENZBETRIEBENER WANDLER FÜR AKUSTISCHE OBERFLÄCHENWELLEN

DIFFERENTIAL-DRIVEN SURFACE ACOUSTIC WAVE TRANSDUCER

(84) Etats contractants désignés:
**CH DE FI FR GB IT LI SE**

(30) Priorité: **07.11.1995 FR 9513132**

(43) Date de publication de la demande:
**09.09.1998 Bulletin 1998/37**

(73) Titulaire: **THOMSON-CSF**
**75008 Paris (FR)**

(72) Inventeurs:
• **DUFILIE, Pierre, Thomson-CSF S.C.P.I.**
**F-94117 Arcueil Cédex (FR)**
• **SOLAL, Marc, Thomson-CSF S.C.P.I.**
**F-94117 Arcueil Cédex (FR)**

(74) Mandataire: **Lincot, Georges et al**
**Thomson-CSF Propriété Intellectuelle,**
**Département Brevets,**
**13, Avenue du Président Salvador Allende**
**94117 Arcueil Cédex (FR)**

(56) Documents cités:
**FR-A- 2 319 245          FR-A- 2 379 941**

• **1973 ultras. symp. proc., Monterey (us),**
**5-7/11/73; p441-444; A. J. De Vries: A Design**
**method for surface wave filters using simple**
**structures as building blocks XP002006332**

## Description

La présente invention se rapporte à un transducteur à ondes acoustiques de surface notamment, un transducteur à ondes acoustique de surface à réflexion acoustique distribuée connu sous la dénomination anglo-saxonne DART, attaqué en différentiel et à entrées/sorties basse impédance. Ce type d'attaque est de plus en plus demandé notamment à cause de l'évolution des circuits intégrés.

La structure de base d'un DART étant supposée connue, elle ne sera donc pas décrite avec détail dans la présente description.

Pour attaquer un transducteur en différentiel, il est nécessaire d'utiliser une structure présentant des entrées différentielles symétriques. La structure de base des DARTs ne permet pas de les utiliser directement en différentiel. En effet, le réflecteur du DART constitue une dissymétrie entre les plages de connexion reliées respectivement aux entrées différentielles.

Des transducteurs et des filtres utilisant ces transducteurs peuvent s'appliquer dans de nombreux domaines tels que les radars ou les systèmes de radiocommunication mobile, en particulier pour le filtrage des fréquences intermédiaires.

Il est connu une structure de DART à entrées différentielles décrites notamment dans un brevet N° 92 10966 intitulé "Transducteur d'ondes unidirectionnel", déposé par la Demanderesse le 15 septembre 1992 et publié sous le N° 2 695 771. Cette structure, permet une alimentation différentielle entre une source positive et négative, référencée par rapport à la masse, et comporte deux cellules émettrices reliées à la source positive encadrant une troisième cellule émettrice reliée à la source négative, et ces trois cellules sont séparées par une première et une deuxième cellules réflectives et reliées éventuellement à la masse, ces cellules étant naturellement mises au potentiel de la masse par symétrie. Cette configuration utilise une structure en méandre dans laquelle les électrodes reliées à la masse s'intercalent entre celles reliées à la source positive et celles reliées à la source négative. Ce méandre pose un problème d'échantillonnage et d'impédance élevée vue par les entrées/sorties de la structure.

Des transducteurs bi-voies sont également connus de FR-A-2 319 245 et de FR-A-2 379 941.

La présente invention a pour but de pallier les inconvénients précités.

A cet effet, l'invention a pour objet un transducteur à ondes acoustiques de surface selon la revendication 1, attaqué en différentiel, caractérisé en ce qu'il est constitué d'au moins un premier transducteur et un deuxième transducteur connectés en parallèle de manière à obtenir la symétrie des entrées différentielles, formant respectivement une première et une deuxième voies acoustiques ; les deux transducteurs présentant un décalage longitudinal déterminé l'un par rapport à l'autre.

L'avantage de la structure du transducteur selon l'invention est de présenter aux entrées/sorties de cette structure des impédances faibles pour une structure à deux voies acoustiques parallèles attaquées en différentiel.

D'autres caractéristiques et avantages de la présente invention seront bien comprises à la lecture de la description qui suit et des figures annexées qui représentent:

- les figures 1a et 1b, un exemple connu de structure d'un transducteur de type DART à entrées non différentielles respectivement en vue de dessus et en coupe,

- les figures 2a, 2b et 2c, un mode de réalisation d'un transducteur comportant deux transducteurs connectés en série pour former un transducteur à entrées différentielles respectivement en vue de dessus et en vues en coupe,

- la figure 3, une première structure d'un transducteur à deux transducteurs en parallèle, attaqués en différentiel et décalés longitudinalement,

- les figures 4a, 4b et 4c, une deuxième structure d'un transducteur selon l'invention comportant deux transducteurs connectés en parallèle, attaqués en différentiel et décalés de λ/2, et leur vue en coupe respective,

- les figures 5a, 5b et 5c, une troisième structure d'un transducteur selon l'invention comportant deux transducteurs connectés en parallèle, attaqués en différentiel et décalés de λ/2, et leur vue en coupe respective,

- les figures 6a, 6b, et 6c, une quatrième structure d'un transducteur selon l'invention comportant deux transducteurs connectés en parallèle, attaqués en différentiel et décalés de λ/2 et leur vue en coupe respective,

- les figures 7a, 7b, et 7c, une cinquième structure d'un transducteur selon l'invention comportant deux transducteurs connectés en parallèle, attaqués en différentiel et décalés de λ, et leur vue en coupe respective,

- la figure 8, une représentation d'un transducteur selon l'invention, décalé d'un nombre pair de demie longueur d'onde, et la forme de l'onde acoustique symétrique générée par le transducteur, et

- la figure 9, une représentation d'un transducteur selon l'invention, décalé d'un nombre impair de demie longueur d'onde, et la forme de l'onde acoustique antisymétrique générée par le transducteur.

Sur ces figures, les éléments homologues sont désignés par les mêmes repères.

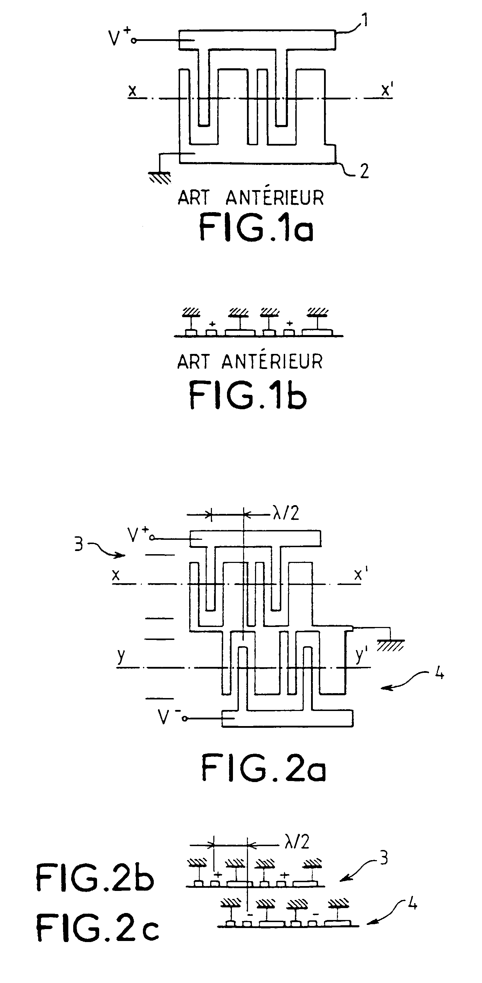

Les figures 1a et 1b illustrent un exemple de structure connue d'un DART à entrées non différentielles. Il est constitué d'une première électrode 1 et d'une deuxième électrode 2 comportant chacune un nombre déterminé de doigts. La première électrode 1 est reliée à un potentiel positif V+ et la deuxième à un potentiel de référence, par exemple la masse; chaque électrode 1, 2 comportant une plage de connexion permettant d'appliquer un potentiel déterminé sur chaque doigt de l'électrode. Chacune des électrodes forme ainsi un peigne et certains des doigts de ces deux électrodes sont entrelacés pour former des cellules émettrices et des cellules réflectrices acoustiques. Le signal acoustique est généré partout où une différence de potentiel électrique est présente.

La figure 1b représente une vue en coupe, selon un axe xx', de la structure illustrée à la figure 1a. Sur cette vue en coupe, on peut distinguer les différents doigts des deux électrodes qui sont déposés à la surface d'un substrat piézo-électrique non représenté. On a représenté également le potentiel de ces doigts.

A partir de cette structure de base en attaque non différentielle, et de la structure, notamment décrite dans le brevet français n°91 12882, déposé le 18.10.91 par la Demanderesse et intitulé "Filtre à ondes de surface et à trajet acoustique replié", et publié sous le n°2 682 833, un transducteur à entrées différentielles peut être aisément construit à partir de deux transducteurs à entrées non différentielles. Pour cela, deux transducteurs, identiques à celui des figures 1a et 1b, sont connectés en série. Les plages de connexion reliées à la masse, respectives à chacun des deux transducteurs, sont communes. Ces deux transducteurs forment respectivement deux voies acoustiques. Ces deux voies acoustiques peuvent apparaître comme une seule voie en décalant les deux voies horizontalement de $\frac{\lambda}{2}$, λ étant la longueur d'onde correspondant à la fréquence centrale de fonctionnement du transducteur.

Une telle structure est illustrée à la figure 2a. Les connexions électriques sont symétriques par rapport à la masse, ce qui entraîne une même impédance vue entre chaque entrée différentielle V+ et V-, référencées par rapport à la masse.

Les figures 2b et 2c représentent respectivement une vue en coupe selon un axe xx' et yy', du premier et du deuxième transducteurs 3 et 4. Comme pour la représentation de la figure 1b, les différents potentiels sont indiqués au-dessus de chaque doigt correspondant aux électrodes reliées, par l'intermédiaire de leurs plages de connexion respectives, aux entrées différentielles.

Un inconvénient majeur d'une telle structure est que l'impédance vue entre les entrées différentielles est égale à quatre fois celle d'une structure à entrées non différentielles ayant la même ouverture que celle utilisée par les deux voies.

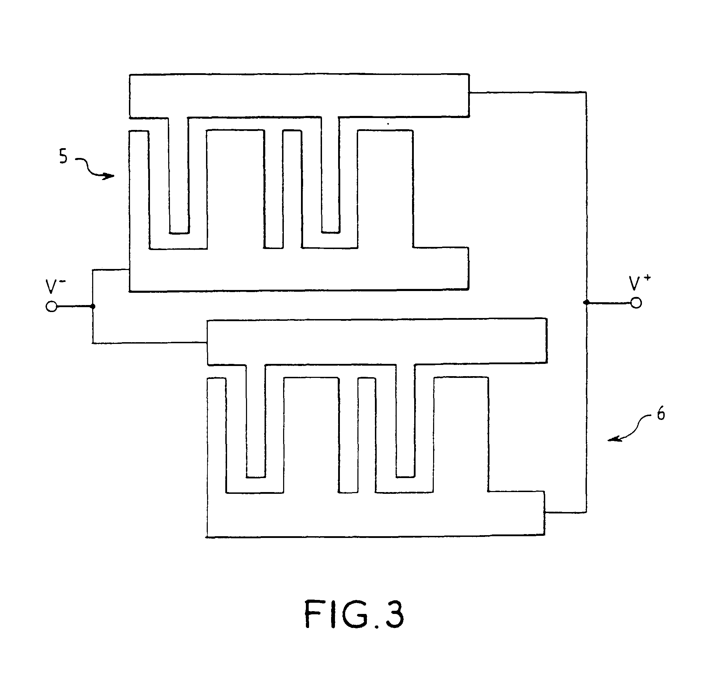

Une première structure d'un transducteur permettant de réduire ces impédances est illustrée à la figure 3.

Dans cette structure, les deux transducteurs déjà décrits dans la structure illustrée à la figure 2a sont connectés en parallèle et non pas en série. Chacun des transducteurs 5 et 6 est branché directement entre les entrées différentielles V+ et V-, le potentiel de référence (la masse) n'étant plus présent. La symétrie des deux accès est rétablie par l'inversion des polarités sur les deux DARTs. Cette inversion de polarité peut être compensée simplement en décalant les deux transducteurs 5 et 6 d'un nombre impair de demies longueurs d'onde, ce qui permet d'obtenir un front d'onde symétrique. Ceci n'est cependant pas obligatoire et on peut très bien accepter de générer un front d'onde antisymétrique, le dispositif et par exemple le transducteur de réception devant être conçu en tenant compte. Ceci entraîne que les impédances vues entre chaque entrée différentielle sont presque égales à celles vues entre les entrées non différentielles d'un transducteur d'ouverture égale à la somme des ouvertures des deux voies acoustiques. On a gagné un facteur 4 par rapport à la structure initiale connectée en série.

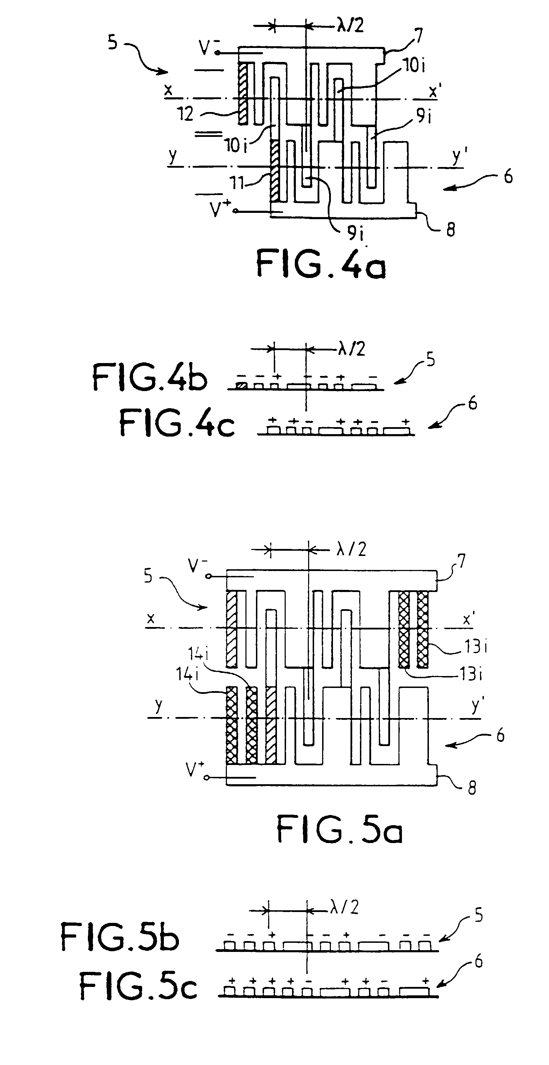

Dans une deuxième structure d'un transducteur selon l'invention, illustrée à la figure 4a, le branchement aux entrées différentielles, équivalent au branchement de la structure précédente, n'utilise que les deux plages de connexion de deux électrodes 7 et 8, chaque plage de connexion étant respectivement branchée à l'une des deux entrées différentielles V+ et V-, et en reliant les doigts 9i et 10i étant reliés entre eux de manière à respecter sur chaque voie la même séquence de polarité sur les différentes électrodes.

Une première voie acoustique est formée à partir de la première électrode 7 connectée à une première entrée différentielle V- par l'intermédiaire de sa plage de connexion. Cette électrode 7 comporte un nombre déterminé de doigts de largeurs déterminées et à des positions déterminées tout le long de l'électrode 7. Une deuxième voie est formée à partir d'une deuxième électrode 8 également en forme de peigne comportant le même nombre de doigts que la première électrode 7, connectée par l'intermédiaire de sa plage de connexion à l'autre entrée différentielle V+. Un même nombre déterminé de doigts 9i et 10i appartenant respectivement aux deux électrodes 7 et 8 sont entrelacés avec les autres doigts des électrodes 7 et 8. Une particularité de cette structure réside dans le fait que le nombre déterminé de doigts 9i de la première électrode 7 appartient à la deuxième voie acoustique, et que le même nombre déterminé de doigts 10i de la deuxième électrode 8 appartient à la première voie acoustique. Les vues en coupe des figures 4b et 4c permettent de comprendre comment les différents potentiels sont répartis sur chaque doigt, respectivement pour le premier transducteur 7 suivant un axe de coupe xx' et pour le deuxième transducteur 8 suivant un axe de coupe yy'.

Le transducteur selon l'invention exploite le fait qu'une onde acoustique est générée par une différence de potentiel appliquée entre deux doigts adjacents et non pas par un potentiel absolu.

Les vues en coupe des figures 4b et 4c comparées respectivement à celles des figures 2b et 2c montrent que la différence de potentiel entre deux doigts adjacents des figures 4a, 4b, 4c est double de celle mesurée entre deux doigts adjacents des figures 2a, 2b, 2c. Ceci est dû au fait que la connexion au potentiel de référence (la masse) a été supprimée. Ainsi comme illustré à la figure 4a, deux doigts ayant la même polarité dans les deux voies sont connectées. Les doigts 9i et 10i des électrodes 7 et 8 qui sont entrelacés avec les autres doigts sont réalisés à partir du prolongement d'autres doigts comme c'est le cas pour la première électrode, ou par le prolongement d'un premier doigt 11, hachuré sur la figure, qui est rajouté pour permettre la connexion au potentiel V+ de la deuxième électrode 8. Un deuxième doigt 12, hachuré, de la première électrode 7 a été également ajouté à la première voie acoustique pour conserver le même nombre de doigts à chacune des voies. Ceci assure une même impédance vue entre les entrées différentielles V+ et V- et donc assure la symétrie des impédances du transducteur.

Comme illustré à la figure 5a, il est possible d'ajouter deux doigts 13i et 14i respectivement aux deux extrémités opposées des deux voies. Ceci permet d'aligner les extrémités des deux voies tout en conservant un nombre de doigts identiques pour les deux voies. Les vues en coupe des figures 5b et 5c permettent de comprendre comment les différents potentiels sont répartis sur chaque doigt, respectivement pour le premier transducteur 7 suivant un axe de coupe xx' et pour le deuxième transducteur 8 suivant un axe de coupe yy'.

Cette structure fonctionne encore si l'on ajoute plus de doigts à une voie qu'à l'autre, cependant la différence entre les nombres de doigts des deux voies doit rester suffisamment petite pour ne pas modifier de manière significative les capacités des entrées différentielles par rapport à la masse.

Concernant ces mêmes impédances, une comparaison entre les structures des figures 2a et 4a révèle que l'impédance de la structure de la figure 4a est approximativement quatre fois plus petite que celle de la figure 2a. Ceci est dû au fait que la structure de la figure 2a est réalisée à partir de la connexion en série des deux transducteurs 3 et 4 référencés par rapport à un potentiel de référence, la masse. La différence de potentiel entre les différentes polarités de la structure de la figure 4a est le double de celle de la structure de la figure 2.

Le décalage de λ/2 du premier transducteur 5 par rapport au deuxième transducteur 6 permet d'obtenir un déphasage nul entre les deux voies à la fréquence centrale f0. D'autre part, ce déphasage permet d'obtenir un zéro à la fréquence 2f0 et donc de supprimer le deuxième harmonique.

Si le décalage des deux transducteurs 5 et 6 n'est pas essentiel, il est néanmoins important car il permet de résoudre un problème de connectique.

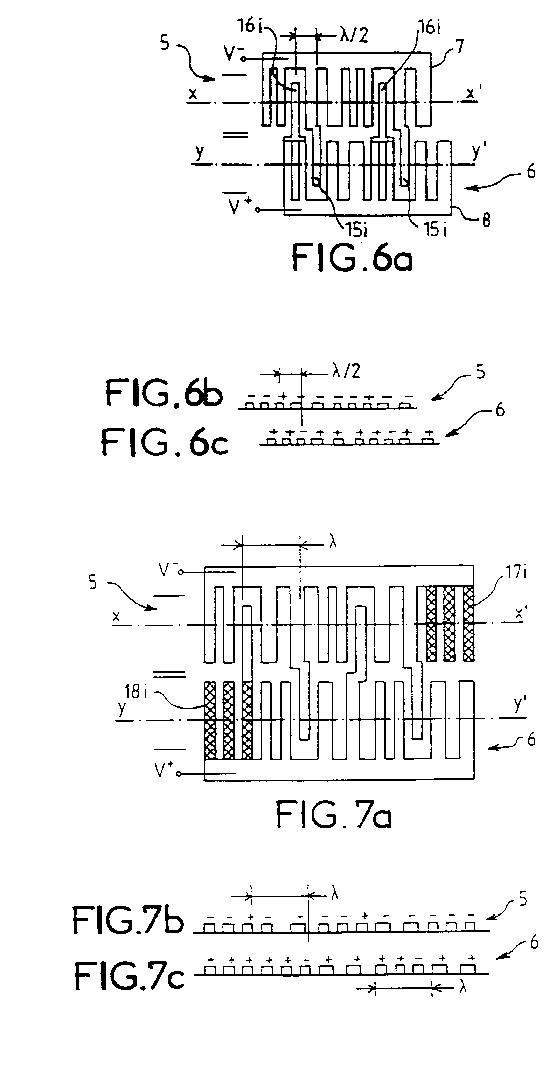

Les figures 6a, 6b, 6c illustrent une application d'un transducteur selon l'invention à une structure différentielle de DART utilisant des sources avec une période de λ/3 et des doigts de largeur λ/6. Dans cette structure, les doigts entrelacés 15i et 16i ne sont pas disposés directement dans le prolongement d'un doigt préexistant de l'électrode 7 et 8. Notamment concernant les doigts 16i appartenant à l'électrode 8 reliée à l'entrée différentielle positive V+ ces doigts 16i, pour un problème de connexion électrique, sont rattachés à l'extrémité de deux doigts adjacents de la même électrode 8 qui sont légèrement rallongés pour permettre la connexion électrique du doigt entrelacé 16i avec le potentiel V+.

Les deux transducteurs 7 et 8 étant, comme pour la structure de la figure 4a, décalés de λ/2, les doigts entrelacés 15i de la première électrode 7 subissent un décalage de λ/2 par rapport aux doigts entrelacés 16i de la deuxième électrode 8.

Les doigts entrelacés 15i de la première électrode 7 se trouvent décalés par rapport aux autres doigts de l'électrode 7 les supportant qui sont également rallongés pour assurer la connexion électrique avec le potentiel V-.

Sur les figures 7a, 7b et 7c, une autre structure d'un transducteur selon l'invention est illustrée.

Dans cette structure, un décalage de λ entre chaque transducteur 5 et 6 est réalisé. Cette structure étant en partie similaire à la structure des figures 6a, 6b et 6c, elle ne sera donc pas redécrite.

Pour respecter un nombre de doigts identique pour chacune des voies, trois doigts 17i et 18i, hachurés sur la figure, sont rajoutés respectivement aux deux extrémités opposées des deux voies.

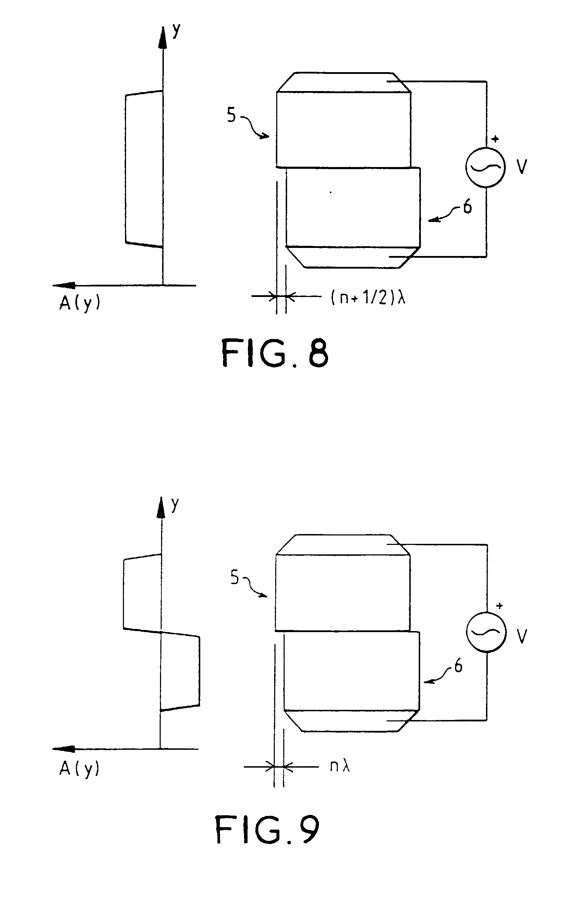

Les figures 8 et 9, illustrent respectivement les deux types de décalages admis par un transducteur selon l'invention.

A la figure 8, le décalage entre les deux voies acoustiques est un multiple impair de λ/2 comme par exemple 3λ/2. Ceci peut être utilisé pour obtenir des zéros supplémentaires dans la fonction de transfert du transducteur. L'onde acoustique A(y) générée est symétrique puisque les ondes acoustiques des deux voies sont en phase.

A la figure 9, le décalage entre les deux voies acoustiques est un multiple pair de λ/2 comme 0 ou λ par exemple. L'onde acoustique A(y) générée est alors antisymétrique.

Il est possible d'utiliser deux transducteurs différents sur les deux voies acoustiques tant que les impédances dans la bande d'utilisation et les capacités restent du même ordre de grandeur.

La présente invention n'est pas limitée aux structures précises qui viennent d'être décrites.

## Revendications

1. Transducteur à ondes acoustiques de surface destiné à être attaqué en différentiel, constitué d'une structure bi-voie, chaque voie étant constituée par un transducteur de voie (5, 6) comportant une pluralité de doigts (12,10i), (11,9i) reliés à l'une ou l'autre des entrées différentielles (V⁺, V⁻), caractérisé en ce que la pluralité de doigts (12,10i), (11,9i) réalise pour chaque voie une succession, de largeurs de doigts, identique entre les deux voies à un décalage près d'un multiple de λ/2 et une succession, de polarités électriques, identique ou opposée entre les deux voies à un décalage près d'un multiple de λ/2 et en ce que chaque transducteur de voie (5, 6) comprend une seule plage de connexion (7, 8) reliée à l'une des entrées différentielles (V⁺, V⁻) et en ce que pour une voie donnée les doigts (10i, 9i) de cette voie qui ont la polarité opposée de la plage de connexion (7, 8) de cette voie sont reliés à la plage de connexion (7, 8) de l'autre voie à travers des doigts (11, 12) rattachés à cette dernière voie.

2. Transducteur selon la revendication 1, caractérisé en ce que le transducteur (5, 6) de chaque voie est du type DART.

**Patentansprüche**

1. Oberflächenschallwellenwandler, der differentiell angesteuert wird und aus einer Zweikanalstruktur gebildet ist, wobei jeder Kanal aus einem Kanalwandler (5, 6) gebildet ist, der mehrere Finger (12, 10i), (11, 9i) enthält, die mit dem einen oder dem anderen der differentiellen Eingänge (V⁺, V⁻) verbunden sind, dadurch gekennzeichnet, daß die mehreren Finger (12, 10i), (11, 9i) für jeden Kanal eine Folge von Fingerbreiten, die bis auf eine Verschiebung um ein Vielfaches von λ/2 völlig gleich sind, und eine Folge von elektrischen Polaritäten, die zwischen den beiden Kanälen bis auf eine Verschiebung um ein Vielfaches von λ/2 gleich oder entgegengesetzt sind, bilden, daß jeder Kanalwandler (5, 6) einen einzigen Verbindungsbereich (7, 8) enthält, der mit einem der differentiellen Eingänge (V⁺, V⁻) verbunden ist, und daß für einen gegebenen Kanal die Finger (10i, 9i) dieses Kanals, die die entgegengesetzte Polarität des Verbindungsbereichs (7, 8) dieses Kanals besitzen, mit dem Verbindungsbereich (7, 8) des anderen Kanals über Finger (11, 12), die an diesen letzten Kanal angefügt sind, verbunden sind.

2. Wandler nach Anspruch 1, dadurch gekennzeichnet, daß der Wandler (5, 6) jedes Kanals vom Typ DART ist.

**Claims**

1. Surface acoustic wave transducer intended to be driven in differential mode, consisting of a two-channel structure, each channel consisting of a channel transducer (5, 6) comprising a plurality of fingers (12, 10i), (11, 9i) linked to one or other of the differential inputs (V⁺, V⁻), characterized in that the plurality of fingers (12, 10i), (11, 9i) produces, for each channel, a succession, of widths of fingers, which is identical for the two channels to within an offset of a multiple of λ/2 and a succession, of electrical polarities, which is identical or opposite for the two channels to within an offset of a multiple of λ/2 and in that each channel transducer (5, 6) comprising a single connection pad (7, 8) linked to one of the differential inputs (V⁺, V⁻) and in that for a given channel the fingers (10i, 9i) of this channel which have the opposite polarity to the connection pad (7, 8) of this channel are linked to the connection pad (7, 8) of the other channel via fingers (11, 12) attached to this latter channel.

2. Transducer according to Claim 1, characterized in that the transducer (5, 6) of each channel is of the DART type.

ART ANTÉRIEUR
## FIG.1a

ART ANTÉRIEUR
## FIG.1b

## FIG.2a

## FIG.2b
## FIG.2c

FIG.3

FIG.4a

FIG.4b
FIG.4c

FIG.5a

FIG.5b
FIG.5c

FIG.6a

FIG.6b
FIG.6c

FIG.7a

FIG.7b
FIG.7c

FIG. 8

FIG. 9